Europäisches Patentamt

(19) European Patent Office

Office européen des brevets

(11) Veröffentlichungsnummer: **0 018 501**
**B1**

(12) **EUROPÄISCHE PATENTSCHRIFT**

(45) Veröffentlichungstag der Patentschrift:
25.05.83

(21) Anmeldenummer: 80101629.6

(22) Anmeldetag: 27.03.80

(51) Int. Cl.³: **H 01 L 21/82,** H 01 L 21/76,
H 01 L 27/10, G 11 C 11/24,
G 11 C 11/34, H 01 L 29/78

(54) Verfahren zur Herstellung von hochverdichteten vertikalen FETs und eine daraus gebildete Matrixanordnung.

(30) Priorität: 07.05.79 US 36722

(43) Veröffentlichungstag der Anmeldung:
12.11.80 Patentblatt 80/23

(45) Bekanntmachung des Hinweises auf die Patenterteilung:
25.05.83 Patentblatt 83/21

(84) Benannte Vertragsstaaten:
DE FR GB

(56) Entgegenhaltungen:
DE-A-2 654 728
IBM TECHNICAL DISCLOSURE BULLETIN, Band
21, Nr. 7, Dezember 1978, New York, US, F.
BARSON: »Dynamic DMOS-random-access memory cell design with trench«, Seiten 2755—2756
IBM TECHNICAL DISCLOSURE BULLETIN, Band
21, Nr. 3, August 1978, New York, US, C. G.
JAMBOTKAR: »Realization of large-value capacitance across base and collector terminals of a
bipolar transistor«, Seiten 1004—1006
IEEE TRANSACTIONS ON ELECTRON DEVICES,
Band ED-25, Nr. 10, Oktober 1978, New York, US,
F. B. JENNE et al.: »A theoretical and experimental analysis of the buried-source VMOS dynamic
RAM cell«, Seiten 1204—1213

(73) Patentinhaber: International Business Machines
Corporation, Armonk, N.Y. 10504 (US)

(72) Erfinder: Ho, Irving Tze, 2 Hight Point Drive,
Poughkeepsie New York 12603 (US)
Erfinder: Riseman, Jacob, 38 Barnard Avenue,
Poughkeepsie New York 12602 (US)

(74) Vertreter: Jost, Ottokarl, Dipl.-Ing., Schönaicher
Strasse 220, D-7030 Böblingen (DE)

## Verfahren zur Herstellung von hochverdichteten vertikalen FETS und eine daraus gebildete Matrixanordnung

Die Erfindung betrifft ein Verfahren und dessen Abwandlungen zur Herstellung von hochverdichteten vertikalen FETs, die gegenseitig dielektrisch isoliert sind, sowie eine aus solchen FETs gebildete Matrixanordnung nach den Oberbegriffen der Ansprüche 1, 6 und 11.

MOSFET-Schaltungen zur Herstellung von Matrixspeichern sind an sich bekannt. So ist beispielsweise in der US-A-4 017 883 ein Matrixspeicher für wahlfreien Zugriff mit ladungsgekoppelten Speicherzellen beschrieben, die in einem Halbleiterkörper gebildet wurden, der in drei zusammenhängende Bereiche längs der planaren Oberfläche des Halbleiterkörpers unterteilt ist. In den ersten Bereich wurde eine Verunreinigung eindiffundiert, so daß dieser alternativ als Source und Drain für Ladungsträger dient. Der zweite oder Gate-Bereich verfügt über eine Schwellenspannung, die durch eine Verunreinigung bestimmt ist, die entweder mittels Diffusion oder Ionenimplantation in diesen Bereich eingebracht wurde. Der dritte oder Speicherbereich weist eine niedrigere Schwellenspannung auf als der Gate-Bereich. Über den zweiten und dritten Bereich erstreckt sich eine einzige gleichförmige Metallelektrode.

In der US-A-3 975 221 ist weiterhin ein MOS-Feldeffekttransistor (MOSFET) mit V-förmigen Gräben beschrieben, der mit einer oberflächendiffundierten Drain und einem gemeinsamen Substrat-Source versehen ist. Eine stark dotierte Basisschicht und ein schwach dotierter Raumladungsbereich sind zwischen Drain- und Source-Bereich angeordnet. Das Gate wird auf der geneigten Oberfläche des V-förmigen Grabens gebildet, die in dem Transistor bis zum Substrat eindringt und die Basisschicht bis auf die Gate-Struktur bloßlegt. Das Gate wird in dem V-förmigen Graben durch eine isolierende Siliciumdioxidschicht und eine leitende Gate-Schicht gebildet. Geeignete Leitungen kontaktieren den Gate-Leiter und den Drain-Anschluß.

Varianten der MOS-Feldeffekttransistorstruktur mit V-förmigen Gräben und Verfahren zur Herstellung solcher Strukturen sind weitgehend bekannt, wie aus den US-A-3 412 297, 4 003 126, 4 084 175 und 4 116 720 sowie den nachfolgenden Veröffentlichungen hervorgeht: »VMOS Memory Technology«, 1977 IEEE International Solid-State Circuits Conference, Digest of Technical Papers, Seiten 74, 75 und 239 sowie »A VMOS-Bipolar Compatible Technology for High-Performance Analog Integrated Circuits«, IEEE Transactions on Electron Devices, June 1977, Seiten 771 bis 773.

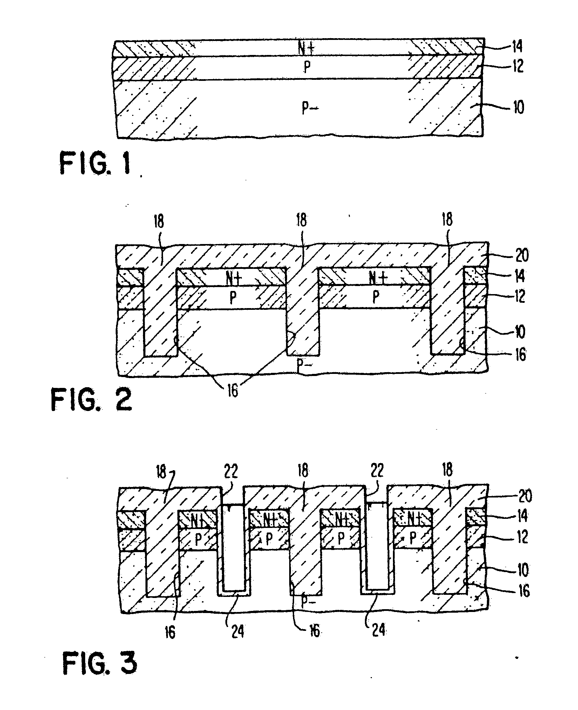

Der V-förmige Graben wird mittels eines anisotropen Ätzens von Silicium hergestellt. Der Ätzvorgang beim Richtungsätzen verläuft in den <100>-Ebenen des Siliciums mit wesentlich größerer Geschwindigkeit als in den <111>-Ebenen, was zu einer scharfen meißelförmigen V-Graben-Geometrie führt. In dem oben erwähnten Beitrag von 1977, auf der IEEE Solid-State Circuits Conference, wurde eine VMOS-Speicherzelle eines Speichers mit wahlfreiem Zugriff angegeben, bei welcher der Speicherknoten als eine vergrabene $N^+$-dotierte Zone ausgebildet ist. Wie Fig. 1 dieses Beitrags zeigt, ist in jeder Zelle ein V-förmiger Graben an der Oberseite eines vergrabenen $N^+$-dotierten Speicherknotens eingeätzt. Alle vier Seiten dieses V-Grabens sind während einer Lese- oder Schreiboperation leitend. Dieses hat ein sehr großes Verhältnis von Kanalbreite zu Kanallänge oder eine sehr kleine Einschaltimpedanz des VMOSFET zur Folge. Bei einem Speicher mit wahlfreiem Zugriff kann der größte Teil der Zugriffsverzögerungszeit den peripheren Schaltungen zuerkannt werden. Die Verzögerung in der Speichermatrix selbst hängt sehr stark von dem Ladungsübertragungsverhältnis ab. Eine VMOS-Zelle erfordert daher einen Kompromiß zwischen gespeicherter Ladung und Matrixdichte, da jede Vergrößerung des V-Grabens die Abmessungen der Speichermatrix beträchtlich vergrößert. In der US-A-4 104 086 schließlich sind Verfahren zur Bildung U-förmiger Gräben in monokristallinem Silicium mit Hilfe der reaktiven Ionenätzung beschrieben. Die Form der Gräben kann so gestaltet werden, daß sie eine leichte Schrägung vorzugsweise zwischen 2° bis 20° gegenüber der Vertikalen haben. Es wird ferner das Auffüllen des Grabens mit dielektrischem Isolationsmaterial beschrieben, wie beispielsweise Siliciumdioxid, um auf diese Weise ein Muster von dielektrischen Isolationen für eine Anzahl von monokristallinen Siliciumbereichen vorzusehen.

Aus der DE-A-2 642 615 ist eine Speichermatrix bekannt, die an der Wand einer V-förmigen Öffnung realisierte Kanäle eines FETs aufweist, bei der in der V-förmigen Öffnung auf einer Gate-Isolierung als Gate-Anschluß dotiertes polykristallines Silicium aufgebracht ist und bei der Teile einer weiteren mit den Gate-Anschlüssen verbundenen, auf einer isolierenden Oberflächenschicht aufgebrachten dotierten polykristallinen Siliciumschicht die Wortleitungen bilden und bei der an die V-förmige Öffnung angrenzende, $N^+$-dotierte einkristalline Siliciumbereiche die Bitleitungen bilden.

Aus der Zeitschrift IBM-Technical Disclosure Bulletin, Vol. 21, Nr. 7, Dezember 1978, Seiten 2755 und 2756 ist ein Verfahren zur Herstellung von vertikalen FETs bekannt, bei dem folgende Verfahrensschritte vorgenommen werden: Ätzen von im wesentlichen U-förmigen Öffnungen durch die Schichten über dem Substrat bis in das Substrat hinein, Aufwachsen von Siliciumdioxid auf die monokristalline Siliciumoberfläche der U-förmigen Öffnungen mittels Oxidation in einer geeigneten Atmosphäre für die Bildung von Gate-Isolationen, und Niederschlagen von dotiertem polykristallinem Silicium in den Öffnungen und auf der Oberfläche einer Siliciumdioxidschicht, so weit bis die Öffnungen aufgefüllt sind.

Die Erfindung hat sich nun die Aufgabe gestellt, ein Verfahren anzugeben, mit dessen Hilfe Speicherzellen sehr kleiner Abmessungen, insbesondere für Lese-/Schreibspeicher für wahlfreien Zugriff, hergestellt werden können. Außerdem soll eine besonders dichte Matrixstruktur aus solchen Speicherzellen angegeben werden.

Gelöst wird diese Aufgabe der Erfindung durch die im Hauptanspruch angegebenen Verfahrensschritte. Eine vorteilhafte Abwandlung des Herstellungsverfahrens ist durch das Merkmal des Anspruchs 6, die vorteilhafte Struktur durch das Merkmal des Anspruchs 11 gekennzeichnet.

Vorteilhafte Ausgestaltungen sind den Unteransprüchen zu entnehmen.

Durch die Erfindung wird der Vorteil erzielt, daß sehr dichte Matrizen von FETs hergestellt werden können, die voneinander dielektrisch getrennt sind und die mehrere vertikale oder leicht gegenüber der Vertikalen geneigte U-förmige Gräben aufweisen. Bei dieser Konfiguration wird der Inversionsladungsspeicherbereich hauptsächlich durch die Tiefe des Grabens bestimmt. Die Dichte einer derartigen U-förmigen MOS-Einelektroden-Speicherstruktur für wahlfreien Zugriff ist somit beträchtlich größer als bei einer Einelektroden-VMOS-Speicherstruktur. Bei der vorgeschlagenen vertikalen MOSFET-Speicherstruktur für wahlfreien Zugriff ist jeweils nur eine von vier Seitenwänden des Grabens leitend. Dieser Speicher für wahlfreien Zugriff ist somit etwa halb so groß wie ein VMOS-Speicher, der in dem Beitrag auf der erwähnten IEEE International Solid-State Circuit Conference beschrieben wurde, mit halb so viel Speicher- und mit halb so viel Bitleitungs-Diffusionsbereichen. Die Dichte der durch die Erfindung verbesserten Struktur ist etwa doppelt so hoch wie bei der Vergleichstype, wobei das Kapazitätsverhältnis zwischen Speicher und Bitleitung ungefähr das gleiche bleibt. Darüber hinaus hat der dünne Siliciumdioxid-Gate-Isolationsbereich eine vierfache Verringerung erfahren, so daß die Zuverlässigkeit eines solchen Speichers ebenfalls besser ist.

Die Verfahren zur Erzeugung einer Matrix von hochverdichteten MOSFETs, die gegenseitig dielektrisch isoliert sind, verwenden Verfahrensschritte der reaktiven Ionenätzung. Diese Technologie verfügt über einen beträchtlichen Vorteil gegenüber dem anisotropen Ätzen, das bei den VMOS-Prozessen eingesetzt wird. Bei dem VMOS-Prozeß ist es notwendig, größere Bereiche zu benutzen, um mehr Speicherbereiche zu erzielen. Um eine höhere Dichte zu erreichen ist auch eine sehr dünne Epitaxieschicht erforderlich, weil der Zellenbereich durch die Tiefe des Grabens und die Tiefe des Grabens ihrerseits durch die Stärke der Epitaxieschicht bestimmt ist. Für eine Epitaxieschicht, beispielsweise der

Stärke von 1 μm ist die Projektionsfläche des Grabens mindestens $3 \times 3$ μm. Dies ergibt sich aus der V-Form, die von dem anisotropen Ätzen des in der $<100>$-Ebene orientierten Siliciums abhängt. Das verwendete reaktive Ionenätzverfahren ist jedoch von der kristallographischen Orientierung des monokristallinen Siliciums unabhängig, und außerdem kann die Tiefe des U-förmigen Grabens so tief gemacht werden, wie es erwünscht ist.

Im folgenden werden Ausführungsbeispiele der Erfindung beschrieben und anhand der Figuren näher erläutert.

Es zeigen Fig. 1—5 Schnittzeichnungen zur Erläuterung eines ersten Verfahrens zur Herstellung einer Matrix aus hochverdichteten vertikalen MOSFETs, die gegeneinander dielektrisch isoliert sind,

Fig. 6 eine Darstellung der elektrischen Schaltung der in den Fig. 4 und 5 dargestellten Halbleiterstruktur,

Fig. 7—13 Darstellungen eines zweiten Ausführungsbeispiels zur Herstellung eines integrierten Speichers für wahlfreien Zugriff, der aus MOSFETs aufgebaut ist und

Fig. 14 eine Darstellung der elektrischen Schaltung der in den Fig. 12 und 13 dargestellten Halbleiterstruktur.

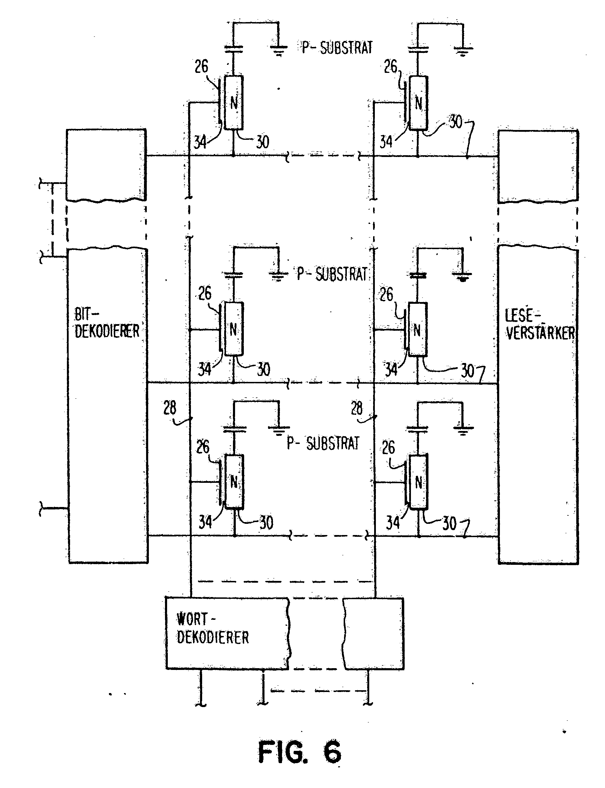

Die Fig. 1 bis 14 zeigen Verfahrensschritte zur Herstellung einer Matrix aus sehr dichten MOS-Feldeffekttransistorstrukturen. Die in Fig. 1 dargestellte Struktur besteht aus einem monokristallinen Siliciumsubstrat 10, das im gewählten Beispiel schwach P-dotiert ist. Ferner ist eine P-dotierte Schicht 12 über dem Substrat 10 angeordnet sowie eine stark N-leitende Schicht 14 über der Schicht 12. Für den Zweck der Erfindung spielt es keine Rolle, wenn alle oder einige der Schichten 10, 12 und 14 vom entgegengesetzten, als dem dargestellten, Leitfähigkeitstyp sind. Die Struktur kann an sich mit Hilfe verschiedener Techniken hergestellt werden. Gemäß der bevorzugten Technik wird jedoch ein monokristallines Siliciumsubstrat mit schwacher P-Dotierung in der $<100>$-Kristallebene verwendet, das eine Dotierungskonzentration von $1 \times 10^{14}$ bis $1 \times 10^{15}$ Atome/dm³ und eine Leitfähigkeit von 100 Ohm $\times$ cm bis 25 Ohm $\times$ cm aufweist. Die P-dotierte Schicht 12 wird vorzugsweise durch epitaxiales Aufwachsen auf das Substrat 10 aufgebracht. Dieses kann mittels konventioneller Verfahren, wie beispielsweise der Verwendung von SiCl₄/H₂- oder SiH₄/H₂-Gemischen bei Temperaturen des Wachstumsvorgangs von etwa 1000°C bis 1200°C durchgeführt werden. Die p-dotierte Schicht kann dabei eine typische Dicke zwischen etwa 0,5 bis 5 Mikrometer (μm) und vorzugsweise eine solche von 2 Mikrometern haben. Die Dotierungskonzentration der Schicht 12 liegt vorzugsweise zwischen $1 \times 10^{16}$ bis $1 \times 10^{17}$ Atomen/cm³ mit einer Leitfähigkeit von 2 Ohm $\times$ cm bis 0,2 Ohm $\times$ cm. Die Schicht 14 kann mit Hilfe eines epitaxialen Wachstumsprozesses hergestellt werden, der demjenigen der P-dotierten Schicht 12 ähnlich ist, jedoch mit Dotierungsmaterial der entgegengesetzten Leitfähigkeit durchgeführt wird. Für die Herstellung der N+-Schicht 14 wird jedoch eine unmaskierte, die gesamte Oberfläche einschließende Diffusion oder ein Ionenimplantationsverfahren bezüglich der P-dotierten Epitaxie-Schicht vorgezogen, die im vorhergehenden Verfahrensschritt aufgewachst wurde.

Die in Fig. 1 dargestellte Struktur ist nun für einen reaktiven Ionenätzprozeß vorbereitet. Dieser Prozeß ist ausführlich in der FR-A-7 610 361 und der US-A-4 104 086 beschrieben. Es sei hier aber kurz erwähnt, daß dieser Prozeß die Bildung einer Maskenschicht (nicht dargestellt) erfordert, die aus Siliciumdioxid oder einer Kombination von Maskenschichten gebildet werden kann, die Siliciumdioxid oder Siliciumnitrid enthalten, die mit Hilfe konventioneller Verfahren auf der Oberfläche der Schicht 14 aufgebracht werden. In den Bereichen, in denen U-förmige Öffnungen gewünscht werden, werden diese dann gebildet. Ein HF-induziertes Plasma wird dadurch reaktionsfähig gemacht, daß es beispielsweise eine Chlorspezies enthält, die in den beiden obengenannten Patentschriften näher angegeben sind. Die genaue Beschreibung der (HF) Hochfrequenz-Glimmentladungsapparatur ist ebenfalls in der oben genannten französischen Patentschrift enthalten. Die Umgebung der reagierenden Ionenätzung oder des Plasmas besteht vorzugsweise aus der Kombination eines inerten Gases, beispielsweise Argon und einer Chlorspezies. Die Anwendung einer geeigneten Leistung in der Größenordnung von etwa 0,1 bis 0,75 W/cm² einer Hochfrequenzspannungsquelle erzeugt eine genügend große Leistungsdichte, um ein reaktives Ionenätzen des Siliciums mit einer Geschwindigkeit von 0,02 bis 0,08 Mikrometer/Minute zu bewirken. Das gewünschte Resultat dieser Ätzung ist in Fig. 2 dargestellt, in der im wesentlichen U-förmige Öffnungen oder Kanäle gezeigt sind, die mindestens teilweise in den Bereich 10 eindringen, der eine P⁻-Leitfähigkeit aufweist. Es ist hierbei jedoch wichtig, daß die Öffnungen oder Kanäle mehr als zwischen 2° bis 20° gegenüber der Vertikalen abgeschrägt sind, wie es in der US-PS 4 104 086 beschrieben ist. Dieses ist deshalb notwendig, weil die nachfolgenden Füllablagerungen zu etwas dickeren Ablagerungen nahe der Oberfläche eines Grabens führen, als an dessen Boden.

Der nächste Verfahrensschritt ist das Auffüllen der Öffnungen 16 mit dielektrischem Material 18. Das Füllen kann durch eine einfache thermische Oxidation der Öffnungen erfolgen, indem der Körper einer Oxidation in nasser Atmosphäre bei 970°C unterworfen wird. Bei einer solchen Atmosphäre kann eine Öffnung mit einer Breite von 2 μm innerhalb von 17 Stunden geschlossen werden. Alternativ hierzu kann auch ein chemisches Niederschlagen dazu verwendet werden, die Öffnungen mit dielektrischem Material aufzufüllen, das aus Siliciumdioxid, Siliciumnitrid, Aluminiumoxid oder Kombination hiervon besteht. Dieser Vorgang ist typischerweise ein chemisches Niederschlagen aus der Gasphase eines Gasgemischs von N₂O, SiH₄ und N₂ bei einer Temperatur des Wachstumsvorgangs von etwa 800°C für die Bildung von Siliciumdioxid. Manchmal wird es auch vorgezogen, eine Kombination des thermisch aufgewachsten Dielektrikums und des chemisch aus der Dampfphase niedergeschlagenen Dielektrikums zu verwenden, da die thermische Siliciumdioxidschicht eine bessere dielektrische Qualität aufweist, gegenüber dem auf der Oberfläche des Siliciums chemisch aus der Gasphase niedergeschlagenen Siliciumdioxids. Auf jeden Fall wird während des Prozesses eine dielektrische Oberflächenschicht 20 entweder mittels thermischen Niederschlags oder durch chemischen Niederschlag aus der Dampfphase gebildet.

Als nächstes wird, wie Fig. 3 zeigt, eine zweite Öffnung oder Rinne 22 durch reaktive Ionenätzung durch die dielektrische Schicht 20, die Schichten 14 und 12 in das Substrat 10 vorgetrieben. Der Prozeß zur Bildung dieser mittels reaktiver Ionenätzung erzeugten Öffnung 22 ist ebenfalls in den oben zitierten Patentschriften erläutert. Das bevorzugte Chlorspezies-ätzmittel für Silicium ätzt langsamer durch die Siliciumdioxidschicht 20 als durch monokristallines Silicium. Wenn es gewünscht wird, kann eine photoresestive Maske (nicht dargestellt) und eine chemische Ätzung verwendet werden, um die Siliciumdioxidschicht 20 durchzuätzen, wobei allerdings eine reaktive Ionenätzung des Siliciums durch die Siliciumdioxidschicht 20, die als Maske dient, nachfolgt. Die gebildete Öffnung ist im wesentlichen U-förmig mit einer leichten Abschrägung gegenüber der Vertikalen von vorzugsweise 2° bis 10°. Die monokristallinen Bereiche zwischen den dielektrischen Isolationsbereichen 18 werden von den U-förmigen Öffnungen 22 im wesentlichen halbiert. Der Halbleiterkörper wird einer oxidierenden Atmosphäre ausgesetzt, die beispielsweise aus Sauerstoff und/oder Dampf von 970°C bestehen kann, um das Gate-Dielektrikum 24 in den Öffnungen zu erzeugen. Die thermische Oxidation ist ein sehr genaues Verfahren zur Erzeugung der gewünschten Stärke des Gate-Dielektrikums für MOSFET-Schaltungen des Halbleiterprodukts. Die Oberflächenschicht 22 wird ebenfalls durch den Oxidationsvorgang leicht verstärkt.

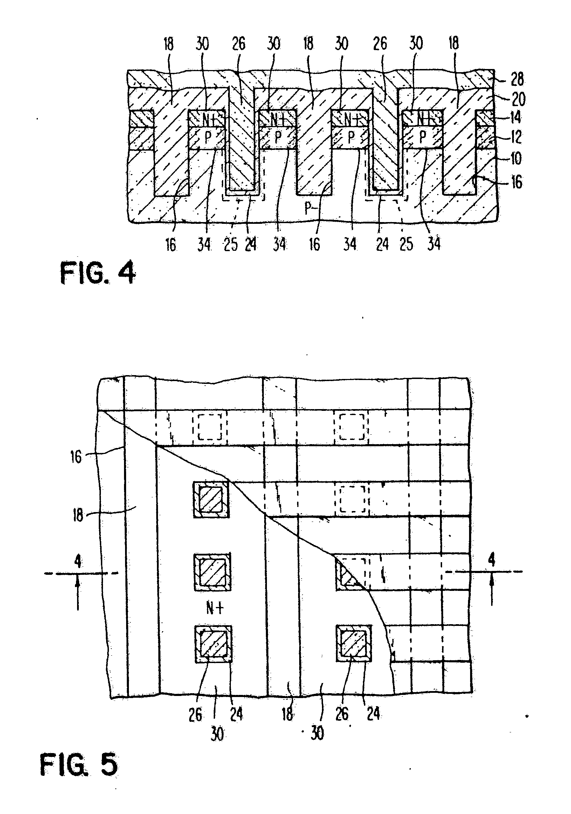

Fig. 4 zeigt die Endstruktur des vorliegenden Prozesses. Um eine Struktur nach Fig. 4 herzustellen, ist es notwendig, eine dotierte Polysiliciumschicht 26 in den Öffnungen 22 niederzuschlagen, die mit der Siliciumdioxidschicht 24 des Gate-Dielektrikums überzogen sind. Das dotierte Polysilicium wird typischerweise mittels eines chemischen Niederschlagens aus der Dampfphase aufgebracht, indem SiH₄, N₂ und ein Dotierungsmaterial, wie beispielsweise PH₃ verwendet wird.

Das chemische Niederschlagen aus der Dampfphase kann alternativ ein reaktionsfähiges Plasma bei seinem Niederschlagen verwenden, bei dem während des Prozesses eine niedrigere Temperatur nöglich ist. Das Dotierungsmaterial ist vorzugsweise N+. Das dotierte polykristalline Silicium bedeckt hierbei die gesamte Oberfläche des Halbleiterkörpers. Um das gewünschte Muster von Wortleitungen auf die Oberflächenschicht 28 aus polykristallinen Silicium zu übertragen, wird die Technik der Photolithographie angewandt. Die Wortleitungen verbinden jeweils die verschiedenen MOSFET-Schaltungen in einem als integrierte Schaltung aufgebauten Lese-/Schreibspeicher. Die N+-Bereiche 30 können als Bitleitungen für eine Zelle eines Lese-/Schreibspeichers verwendet werden. Der Kanal für den FET ist die P-dotierte Region 34. Die mit dotiertem polykristallinem Material gefüllte Öffnung 26 ist dann der Gate-Anschluß. Der Kondensator dieser Ein-Element MOSFET-Speicherzelle eines Speichers mit wahlfreiem Zugriff besteht aus dem Verarmungsbereich 25, der in den P−-dotierten Substrat gebildet wurde, welcher die dielektrische Schicht 24 des Gates und deren Anschluß 26 umgibt.

Fig. 5 zeigt eine Aufsicht auf die Oberfläche des in Fig. 4 dargestellten Schnittes. Fig. 4 zeigt den Schnitt 4-4, der aus Fig. 5 hervorgeht.

Der Betrieb einer Schaltungsstruktur nach den Fig. 4, 5 ist besser im Zusammenhang mit den Fig. 4, 5 und 6 zu beschreiben. Während einer Schreiboperation wird eine positive Spannung an die Wortleitung 28 angelegt. Der Kanal 34 wird daraufhin leitend. Das Einschreiben einer binären 1 oder einer 0 wird von der Spannung an der Bitleitung bestimmt, die jeweils einen hohen oder einen niedrigen Pegelwert einnimmt. Mit diesen Pegeln wird gesteuert, ob elektrische Ladungen in der Potentialmulde 25 gespeichert sind oder nicht, wobei diese Mulde in dem P−-dotierten Substrat in der Nähe des dünnen Gate-Oxids 24 gebildet ist, so wie es auch bei dem Betrieb einer ladungsgekoppelten Speichervorrichtung (CCD) der Fall ist.

Am Ende einer Schreiboperation fällt die Wortleitungsspannung auf ihren Ruhepegel zurück und scnaltet dadurch den Kanal ab, bevor die Bitleitung zu ihrem Ruhezustand zurückkehrt. Die Ruhespannung der Wortleitung sollte genügend hoch sein, um die Potentialmulden dieser Speicherzellen aufrecht zu erhalten.

Während einer Leseoperation fällt die Wortleitungsspannung ab, in typischer Weise bis auf 0 Volt. Das Oberflächenpotential sinkt dadurch ab, und die Ladungen, die ursprünglich in den Potentialmulden gespeichert waren, fließen nach außen auf die Bitleitungen ab und werden abgefühlt. Die Bitleitung wird hierbei auf einer positiven Spannung gehalten. Einzelheiten des oben beschriebenen Speicherzellenbetriebs sind in dem Aufsatz »The Charge-Coupled RAM Cell Concept« von A. F. Tasch beschrieben, der im IEEE Journal of Solid-State Circuits, Vol. SC-11, Nr. 1, Februar 1976, auf den Seiten 58 bis 63 veröffentlicht ist.

Wenn die Ladungen von einer bestimmten Potentialmulde während einer Leseoperation nach außen abgeleitet werden, ist es wichtig, daß alle ihre Ladungen auf die entsprechende Bitleitung fließen, ohne daß sie in irgendwelche benachbarten Potentialmulden parasitär abfließen, was Störsignal-Koppelprobleme mit sich brächte. Benachbarte Potentialmulden, die mit verschiedenen Bitleitungen verbunden sind, werden durch Oxidgräben 16 gegeneinander isoliert, so daß Störsignalkopplungen vermieden werden. Ferner ist es möglich, eine zweidimensionale Oxidisolation (in Fig. 4 nicht dargestellt) aufzubauen, um eine Störsignalkopplung auf der gleichen Bitleitung zu vermeiden, sollte dies erforderlich sein.

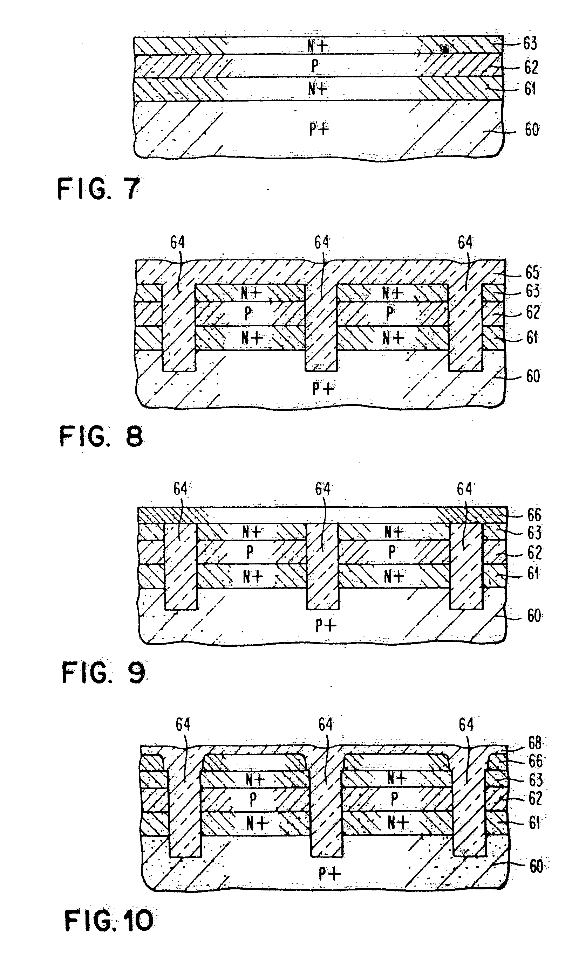

Ein zweites Ausführungsbeispiel ist in den Fig. 7 bis 14 dargestellt. Diesem Ausführungsbeispiel ist der Vorzug zu geben, da es zu einer MOSFET-Struktur für einen Speicher mit wahlfreiem Zugriff führt, die vertikale Ein-Kanal FETs realisiert, die an den Seitenflächen der Gräben realisiert sind. Dieser Speicher mit wahlfreiem Zugriff ist etwa nur halb so groß wie bisher bekannte VMOSFET-Speicher mit wahlfreiem Zugriff. Darüber hinaus bleibt das Kapazitätsverhältnis von Speicher zu Bitleitung trotz dieser Größenreduzierung etwa gleich.

Fig. 7 zeigt nun insbesondere die Struktur, die sich aus einem solchen Prozeß nach einer Reihe von Epitaxie- und/oder Diffusionsschritten ergibt. Die Struktur besteht aus einem monokristallinen Siliciumsubstrat 60, das eine beliebige kristallographische Orientierung haben kann, einer darüberliegenden N+-dotierten Schicht 61, einer über der N+-dotierten Schicht liegende P-dotierten Schicht 62 und einer zweiten N+-dotierten Schicht 63, die über der P-leitenden Schicht liegt. Das P+-dotierte Substrat möge eine Leitfähigkeit von $1 \times 10^{18}$ Atome/cm$^3$ oder mehr haben. Die Schichten 61, 62 und 63 können mit Hilfe üblicher epitaxialer Aufwachstechniken gebildet werden, also solchen Verfahren, die bereits im Zusammenhang mit den Fig. 1 bis 5 erläutert wurden. Alternativ hierzu können auch die Reihen von Schichten mit Hilfe von Kombinationen zwischen epitaxialem Aufwachsen und/oder unmaskierten Diffusionsschritten gebildet werden. Die Leitfähigkeit der Schicht 61, der hier der Vorzug gegeben wird, beträgt $10^{20}$ Atome/cm$^3$. Die Leitfähigkeit der P-dotierten Schicht 62 wird mit $1 \times 10^{16}$ bis $1 \times 10^{17}$ Atome/cm$^3$ und diejenige der N+-dotierten Schicht 63 mit $10^{20}$ Atome/cm$^3$ gewählt.

Mit Hilfe reaktiver Ionenätzverfahren, die bereits im Zusammenhang mit dem ersten Ausführungsbeispiel beschrieben wurden, werden U-förmige Öffnungen in den Halbleiterkörper gebracht, indem die Ätzung durch ein geeignetes Muster einer Maskenschicht in das P+-dotierte Substrat 60 vorgetrieben wird. Das Ergebnis dieses Verfahrensschritts ist ein Muster von Öffnungen, die Bereiche monokristallinen Siliciumsubstrats und der darüberliegenden Schichten gegeneinander isolieren. Die so entstandenen Öffnungen des Musters werden dann mit dielektrischem Material, wie beispielsweise Siliciumdioxid, Siliciumnitrid, Aluminiumtrioxid und/oder Kombinationen dieser Materialien gefüllt. Diese gefüllten Öffnungen werden dann als dielektrische Isolationsbereiche 64 betrachtet. Während des Löcherfüllvorgangs wird das dielektrische Material auch auf der Oberfläche des Halbleiterkörpers als Schicht 65 abgelagert. Diese Schicht 65 wird von der N+-dotierten Schicht 63 vollständig durch reaktive Ionenätzung entfernt. Das Ergebnis dieser reaktiven Ionenätzung sind die N+-Inseln an der Oberfläche der dielektrischen Siliciumdioxid-Füllschicht 64. Über der gesamten Oberfläche wird dann eine Schicht 66 aus hochdotiertem N+-polykristallinem Silicium aufgebracht, so daß nun eine Struktur entstanden ist, die Fig. 9 zeigt.

Mittels Photolithographie werden nun Öffnungen in die polykristalline Siliciumschicht 66 über den mit Siliciumdioxid aufgefüllten Öffnungen 64 eingebracht. Der Halbleiterkörper wird dann einer Oxidationsatmosphäre mit einer Temperatur von 970° C und nassem Sauerstoff ausgesetzt, um eine Oxidschicht 68 über der N+-dotierten polykristallinen Schicht 66 zu erzeugen. Die entstandene Struktur ist in Fig. 10 zu erkennen.

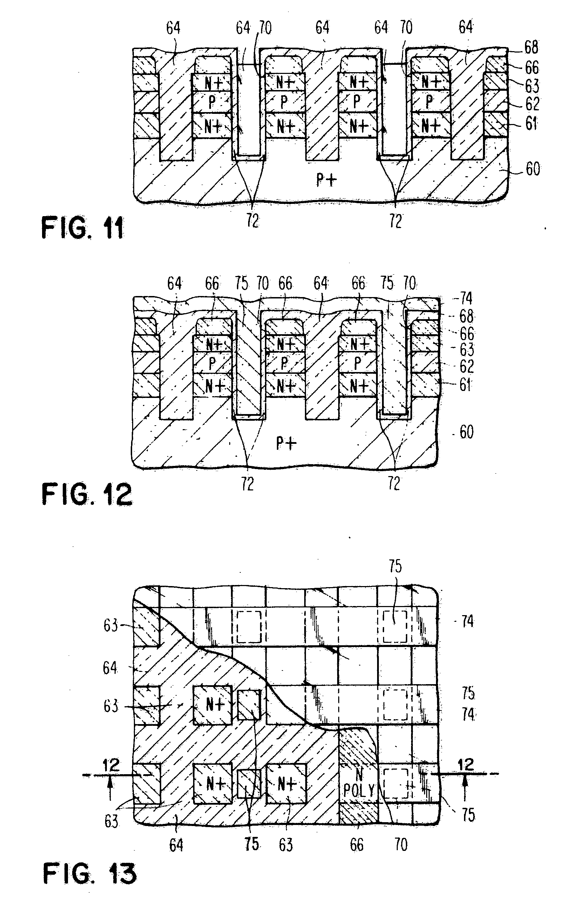

Als nächstes wird, wie Fig. 11 zeigt, eine zweite reaktive Ionenätzung vorgenommen, die tiefe Öffnungen und Gräben 20 durch die dielektrische Schicht 68 und die Schichten 66, 63, 62 und 61 bis in das P+-leitende Substrat 60 vorantreibt. Der Vorgang für die Bildung der Öffnung 70 mittels reaktiver Ionenätzung ist bereits im Zusammenhang mit der eingangs erwähnten FR-A-7 610 361 sowie im Zusammenhang mit dem ersten Ausführungsbeispiel in Fig. 3 erläutert worden. Die entstandene Öffnung ist im wesentlichen U-förmig mit einer leichten Abschrägung gegenüber der Vertikalen und vorzugsweise 2° bis 10°. Die Bereiche monokristallinen Siliciums zwischen den dielektrischen Isolationsbereichen 64 werden im wesentlichen durch U-förmige Öffnungen 70 halbiert. Die Öffnungen 70 isolieren die halbierten Bereiche aus monokristallinem Silicium gegeneinander, da sie sich von einem dielektrischen Bereich zum nächsten erstrecken. Dieses Konzept geht aus Fig. 13 hervor, das im folgenden erläutert werden soll. Der Siliciumdioxid-Isolator 72 für ein Gate wird dadurch gebildet, daß der Halbleiterkörper einer Oxidationsatmosphäre von beispielsweise 970° C in Sauerstoff oder Wasserdampf ausgesetzt wird. Die Stärke dieses Gate-Dielektrikums kann beispielsweise zwischen etwa 400 bis 1000 Angström liegen. Die Abmessungen des Gates können zusammen mit anderen kritischen Abmessungen der Schaltung gemäß den Maßstabsregeln für MOSFET geändert werden, die in dem Aufsatz »Design of Ion-Implanted MOSFETs With Very Small Physical Dimensions« von R. H. Dennard, et alita, in den IEEE J. Solid-State Circuits Vol. SC-9, Nr. 5, Seiten 256 bis 268, Oktober 1974 beschrieben sind. Das Ergebnis dieses Prozesses ist die in Fig. 11 dargestellte Struktur.

Die abschließenden Verfahrensschritte des als zweites Ausführungsbeispiel beschriebenen Prozesses werden im folgenden anhand der Fig. 12 und 13 näher erläutert. Die dotierte polykristalline Schicht 74, typischerweise hergestellt durch ein chemisches Niederschlagen aus der Dampfphase, wie es im Zusammenhang mit Fig. 4 schon erläutert wurde, wird in den Öffnungen 70 niedergeschlagen, die das Gate-Dielektrikum 72 enthalten sowie über der gesamten Oberfläche der Siliciumdioxidschicht 68. Das dotierte polykristalline Silicium innerhalb der Öffnungen wirkt wie ein Gate-Anschluß 75. Das gewünschte Muster von Wortleitungen wird nun photolithographisch auf die Oberflächenschicht des vorzugsweise verwendeten polykristallinen N+-dotierten Siliciums aufgebracht. Auf die gesamte Struktur werden nun Passivierungsschichten aufgebracht, welche die integrierte Schaltung gegen Verunreinigungen der Umgebungsatmosphäre abschirmen. Diese Passivierungsüberzüge werden mit Hilfe bekannter Verfahren aufgebracht.

Fig. 13 zeigt eine Aufsicht auf die Struktur der integrierten Schaltung, bei der die Oberflächenschicht teilweise entfernt ist. Fig. 12 zeigt einen Schnitt längs der Linie 12-12 in Fig. 13. Die polykristalline N+-dotierte Siliciumschicht 66 stellt die Bitleitung des Speichers dar. Die N+-dotierten Schichten 61 und 63 sind die Source-/Drain-Bereiche des MOSFET. Die P-leitende Schicht 62 trennt die N+-dotierten Schichten 61 und 63 voneinander und liefert den Bereich für den MOSFET-Kanal. Die Verbindung zwischen dem P+-dotierten Substrat 60 und der N+-dotierten Schicht 61 bildet den Kondensator der Speicherzelle.

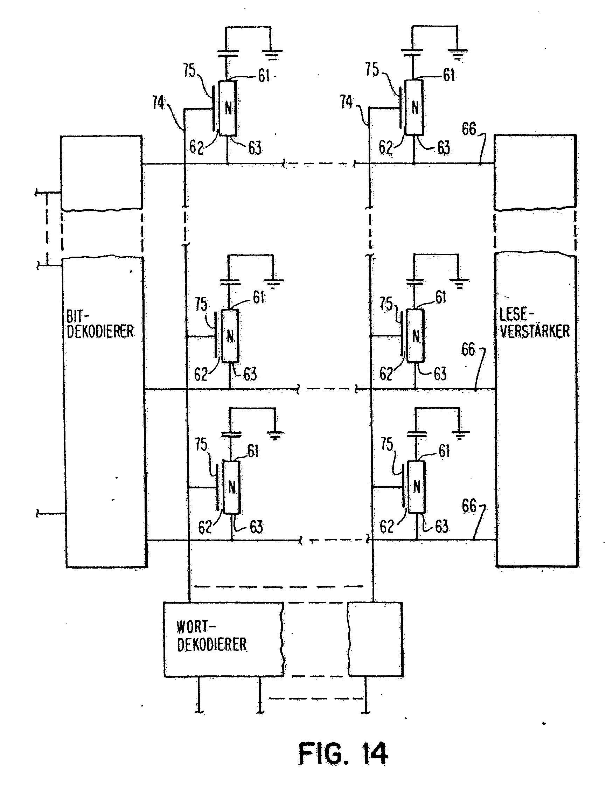

Fig. 14 zeigt die elektrischen Belange der in den Fig. 12 und 13 dargestellten Ausführungsbeispiele. Gleiche Bezugszeichen in den Fig. 12, 13 und 14 zeigen auch die gleichen konkreten Elemente. Die Bitleitungen 66 verbinden die Speicherzelle mit dem Leseverstärker und die Wortleitungen 74 mit den Worttreibern. Die Speicherzelle ist grundsätzlich eine dynamische Ein-Elementzelle, wie sie in der US-A-3 387 286 beschrieben ist.

Die Betriebsweise der Ausführungsbeispiele in den Fig. 12 und 13 wird im folgenden unter Bezugnahme auf Fig. 14 näher erläutert. Der Betrieb dieser Speicherzellen ist dem in der genannten US-PS 3 387 286 sehr ähnlich. Während der Schreiboperation wird eine positive Spannung an die Wortleitung 74 angelegt, die den Kanal 72 leitend macht. Das Einschreiben einer binären 1 oder einer binären 0 wird durch die Spannung an der Bitleitung 66 bestimmt, die für eine binäre 1 einen hohen und für eine binäre 0 einen niedrigen Signalpegel annehmen muß. Diese Signalpegel bestimmen, ob elektrische Ladungen in dem Kondensator am PN-Übergang gespeichert sind oder nicht, der zwischen dem N+-Knoten 61 und dem P+-dotierten Substrat gebildet ist, wobei sich der Kondensator dadurch ergibt, daß anstelle des konventionellen P⁻-dotierten Substrats hier ein P+-dotiertes Substrat verwendet wird.

Am Ende einer Schreiboperation sinkt die Spannung an der Wortleitung bis auf den Ruhepegel und schaltet auch den Kanal ab, bevor die Spannung an der Bitleitung ebenfalls auf ihren Ruhepegel abfällt.

Während einer Leseoperation steigt die Spannung an der Wortleitung wieder an und schaltet auch den Kanal ein, so daß die im Kondensator gespeicherten Ladungen über die Bitleitung zurückfließen und dort abgefühlt werden können.

## Patentansprüche

1. Verfahren zur Herstellung einer Matrix aus hochverdichteten vertikalen FET's, die gegenseitig dielektrisch isoliert sind, gekennzeichnet durch folgende Verfahrensschritte:

— Aufbringen einer N+-dotierten Schicht (14) über einer auf einem P-leitenden monokristallinen Siliciumsubstrat (10) aufgebrachten P-dotierten Schicht (12),
— Ätzen eines Musters von ersten U-förmigen Öffnungen (16) in den Halbleiterkörper bis in das P-leitende Substrat mittels reaktiven Ionenätzens, wodurch Bereiche des monokristallinen Siliciumsubstrats und seiner aufgebrachten Schichten gegenseitig isoliert werden,
— Auffüllen der Öffnungen mit Siliciumdioxid (18) und Bildung einer Siliciumdioxidschicht (20) über der N+-dotierten Schicht (14),
— Ätzen von zweiten im wesentlichen U-förmigen Öffnungen (22) durch die Schichten (19, 14) über dem P-leitenden Substrat (10) bis in das Substrat (10) hinein mittels reaktiver Ionenätzung zur Halbierung der gegenseitig isolierten monokristallinen Siliciumbereiche,
— Aufwachsen von Siliciumdioxid (24) auf die monokristalline Siliciumoberfläche der zweiten U-förmigen Öffnungen (22) mittels thermischer Oxidation in einer geeigneten Atmosphäre für die Bildung von Gate-Isolationen,
— Niederschlagen von dotiertem polykristallinem Silicium (26, 28) in den zweiten Öffnungen (22) und auf der Oberfläche der Siliciumdioxidschicht (20) so weit bis die zweiten Öffnungen (22) aufgefüllt sind und
— Wegätzen des dotierten polykristallinen Siliciums (28) zur Bildung von Wortleitungen eines Speichers.

2. Verfahren nach Anspruch 1, dadurch gekennzeichnet, daß die FET's zu einem Speicher mit wahlfreiem Zugriff derart angeordnet werden, daß die N+-dotierte Schicht (14) zwischen den ersten U-förmigen und mit Siliciumdioxid (18) aufgefüllten Öffnungen (16) und den zweiten U-förmigen und mit polykristallinen Silicium (26) aufgefüllten Öffnungen (22) die Bitleitungen (30) des Speichers und die p-dotierte Schicht (12) die Kanäle der FET's bilden.

3. Verfahren nach Anspruch 1 oder 2, dadurch gekennzeichnet, daß die U-förmigen Öffnungen an der Oberfläche etwas größer sind als an ihrem Boden.

4. Verfahren nach einem der Ansprüche 1 bis 3, dadurch gekennzeichnet, daß die P-dotierte Schicht (12) mittels epitaxialen Aufwachsens auf dem P-leitenden Substrat (10) aufgebracht und die N+-dotierte Schicht (14) mit Hilfe einer unmaskierten, die gesamte Oberfläche einschließenden Diffusion auf die Oberfläche der epitaxialen P-leitenden Schicht aufgebracht wird.

5. Verfahren nach einem der Ansprüche 1 bis 3, dadurch gekennzeichnet, daß die P-dotierte Schicht (12) auf dem P-leitenden Substrat (10) und die N+-dotierte Schicht (14) auf der Oberfläche der P-leitenden Schicht (12) mit Hilfe epitaxialen Aufwachsens aufgebracht werden.

6. Verfahren zur Herstellung einer Matrix aus hochverdichteten vertikalen FET's, die an den Wänden von Gräben in einem Halbleiterkörper realisiert sind, dadurch gekennzeichnet, daß zum Aufbau der Speichermatrix für wahlfreien Zugriff folgende Verfahrensschritte ausgeführt werden:

— Aufbringen einer ersten N+-dotierten Schicht (61) auf einem P-leitenden monokristallinen Siliciumsubstrat (60), Aufbringen einer P-dotierten Schicht (62) auf der ersten N+-dotierten Schicht (61) und Aufbringen einer zweiten N+-dotierten Schicht (63) auf der P-dotierten Schicht (62),
— Ätzen eines Musters von ersten U-förmigen Öffnungen in den Halbleiterkörper mittels reaktiven Ionenätzens, wodurch Bereiche des monokristallinen Siliciumsubstrats und seiner aufgebrachten Schichten gegenseitig isoliert werden,
— Auffüllen der ersten U-förmigen Öffnungen mit Siliciumdioxid (64),
— Wegätzen jeglichen Materials von der Oberfläche der zweiten N+-dotierten Schicht (63),
— Aufbringen einer ersten N+-dotierten polykristallinen Siliciumschicht (66) auf der Oberfläche der zweiten N+-leitenden Schicht (63) und auf den mit Siliciumdioxid aufgefüllten Öffnungen,
— Herstellen von Öffnungen in der ersten polykristallinen Siliciumschicht (66) über den mit Siliciumdioxid (64) aufgefüllten ersten Öffnungen,
— Aufwachsen einer isolierenden Oberflächenschicht (68) auf der Oberfläche der ersten polykristallinen Siliciumschicht (66),

- Ätzen von zweiten im wesentlichen U-förmigen Öffnungen (70) durch die Schichten (61, 62, 63, 66) über dem P-leitenden Substrat (60) bis in das Substrat (60) hinein mittels reaktiver Ionenätzung zur Halbierung der gegenseitig isolierten monokristallinen Siliciumbereiche,
- Aufwachsen von Siliciumdioxid (72) auf die monokristalline Siliciumoberfläche der zweiten U-förmigen Öffnungen (70) mittels thermischer Oxidation in einer geeigneten Atmosphäre zur Bildung von Gate-Isolationen,
- Niederschlagen von dotiertem polykristallinem Silicium (74, 75) in die zweiten U-förmigen Öffnungen und auf die isolierende Oberflächenschicht (68), so weit, bis die zweiten U-förmigen Öffnungen aufgefüllt sind und sich auf der isolierenden Oberflächenschicht (68) eine zweite polykristalline Siliciumschicht (74) ausgebildet hat und schließlich
- Wegätzen von Teilen der zweiten polykristallinen Siliciumschicht (74) zur Bildung von Wortleitungen eines Speichers für wahlfreien Zugriff.

7. Verfahren nach Anspruch 6, dadurch gekennzeichnet, daß die N+-leitenden und P-leitenden Schichten (61, 62, 63) mit Hilfe epitaxialen Aufwachsens gebildet werden.

8. Verfahren nach Anspruch 6 oder 7, dadurch gekennzeichnet, daß die ersten U-förmigen Öffnungen dadurch mit Siliciumdioxid gefüllt werden, daß der Halbleiterkörper einer Oxidationsatmosphäre und einer angehobenen Temperatur zur thermischen Oxidation der Siliciumoberflächen in den ersten U-förmigen Öffnungen ausgesetzt wird.

9. Verfahren nach einem der Ansprüche 6 bis 8, dadurch gekennzeichnet, daß eine Passivierungsschicht über der gesamten Oberfläche der Speichermatrix aufgebracht wird.

10. Verfahren nach einem oder mehreren der Ansprüche 6, 8 oder 9, dadurch gekennzeichnet, daß die erste N+-dotierte Schicht (61) und die P-dotierte Schicht (62) mittels epitaxialen Aufwachsens hergestellt werden und die zweite N+-dotierte Schicht (63) mittels einer N+-dotierten Ausdiffusion aus der ersten N+-dotierten polykristallinen Schicht in einen Bereich von der Dicke der P-leitenden Schicht eingebracht wird.

11. Nach dem Verfahren gemäß einem der Ansprüche 6 bis 10 hergestellte, hochverdichtete FET-Speichermatrix für wahlfreien Zugriff, gekennzeichnet durch folgende Struktur:

- die gegenseitig isolierten monokristallinen Siliciumbereiche sind jeweils durch die zweiten U-förmigen Öffnungen (70) in zwei gleich große Hälften unterteilt.
- das leitfähige polykristalline Silicium (75) in den zweiten U-förmigen Öffnungen (70) ist jeweils über Bereiche der zweiten polykristallinen Siliciumschicht (74) mit denjenigen in einer Zeile von analogen Öffnungen verbunden,
- die N+-dotierten Schichten (61, 63) sind Source/Drain, die P-dotierte Schicht (61) zwischen den N+-dotierten Schichten (61, 63) bildet den Kanal, die erste N+-dotierte polykristalline Siliciumschicht (66) bildet einen Kontakt mit der zweiten N+-dotierten Schicht (63) das leitfähige polykristalline Silicium (75) in den zweiten U-förmigen Öffnungen bildet den Gate-Anschluß der FET's und
- Bereiche der ersten polykristallinen Siliciumschicht (66) sind mit in einer Spalte angeordneten analogen Bereichen verbunden und bilden die Bitleitung, der PN-Übergang zwischen dem P-leitenden Substrat (60) und der ersten N+-dotierten Schicht bilden den Speicherkondensator einer Speicherzelle.

12. Speichermatrix nach Anspruch 11, dadurch gekennzeichnet, daß die isolierende Oberflächenschicht (68) aus einem Siliciumdioxidüberzug besteht.

## Claims

1. Method of making a matrix of high density vertical FETs dielectrically isolated from each other, characterized by the following process steps:

- applying an N+-doped layer (14) over a P-doped layer (12) on a P-conductive monocrystalline silicon substrate (10),
- etching a pattern of first U-shaped openings (16) in the semiconductor body into the P-conductive substrate by means of reactive ion etching, so that regions of the monocrystalline silicon substrate and its deposited layers can be isolated relative to each other, filling the openings with silicon dioxide (18), and forming a silicon dioxide layer (20) over the N+-doped layer (14),
- etching second substantially U-shaped openings (22) through the layers (19, 14) over the P-conductive substrate (10) into the substrate (10) by means of reactive etching to bisect the mutually isolated monocrystalline silicon regions,
- growing silicon dioxide (24) onto the monocrystalline silicon surface of the second U-shaped openings (22) by thermal oxidation in a suitable ambient for the forming of gate isolations,
- depositing doped polycrystalline silicon (26, 28) in the second openings (22) and on the surface of the silicon dioxide layer (20) until the second openings (22) are filled, and
- etching the doped polycrystalline silicon (28) to form word lines of a storage.

2. Method as claimed in claim 1, characterized in that the FETs are arranged into a random access storage in such a manner that the N+-doped layer (14) between the first U-shaped openings (16) filled with silicon dioxide (18), and the second U-shaped openings (22) filled with polycrystalline silicon (26) forms the bit lines (30) of the storage, and the P-doped layer (12) forms the channels of the FETs.

3. Method as claimed in claim 1 or 2, characterized in that the U-shaped openings on the surface are slightly larger than at the bottom.

4. Method as claimed in any one of the claims 1 to 3, characterized in that the P-doped layer (12) is applied on the P-conductive substrate (10) by means of epitaxial growth, and that the N+-doped layer (14) is applied by means of an unmasked blanket diffusion onto the surface of the epitaxial P-conductive layer.

5. Method as claimed in any one of claims 1 to 3, characterized in that the P-doped layer (12) on the P-conductive substrate (10), and the N+-doped layer (14) on the surface of the P-conductive layer (12) are applied by means of epitaxial growth.

6. Method of making a matrix of highly dense vertical FETs realized at the walls of grooves in a semiconductor body, characterized in that for designing the storage matrix for random access the following process steps are executed:

— applying a first N+-doped layer (61) on a P-conductive monocrystalline silicon substrate (60), applying a P-doped layer (62) on the first N+-doped layer (61) and applying a second N+-doped layer (63) on the P-doped layer (62),

— etching a pattern of first U-shaped openings in the semiconductor body by means of reactive ion etching, so that regions of the monocrystalline silicon substrate and of its applied layers are mutually isolated,

— etching any material from the surface of the second N+-doped layer (63),

— applying a first N+-doped polycrystalline silicon layer (66) on the surface of the second N+-conductive layer (63) and on the silicon dioxide-filled openings,

— forming openings in the first polycrystalline silicon layer (66) over the first openings filled with silicon dioxide (64),

— growing an isolating surface layer (68) on the surface of the first polycrystalline silicon layer (66),

— etching second substantially U-shaped openings (70) through the layers (61, 62, 63, 66) over the P-conductive substrate (60) into the substrate (60) by means of reactive ion etching to bisect the mutually isolated monocrystalline silicon regions,

— growing silicon dioxide (72) onto the monocristalline silicon surface of the second U-shaped openings (70) by means of thermal oxidation in a suitable ambient to form gate insulators,

— depositing doped polycrystalline silicon (74, 75) in the second U-shaped openings and on the isolating surface layer (68) until the second U-shaped openings are filled, and a second polycrystalline silicon layer (74) has formed on the isolating surface layer (68), and finally

— etching parts of the second polycrystalline silicon layer (74) to form word lines of a random access storage.

7. Method as claimed in claim 6, characterized in that the N+-conductive and P-conductive layers (61, 62, 63) are formed by means of epitaxial growth.

8. Method as claimed in claims 6 or 7, characterized in that the first U-shaped openings are filled with silicon, in that the semiconductor body is exposed to an oxidation ambient and to an elevated temperature to thermally oxidize the silicon surfaces in the first U-shaped openings.

9. Method as claimed in any one of claims 6 to 8, characterized in that a passiviation layer is deposited over the entire surface of the storage matrix.

10. Method as claimed in one or more of claims 6, 8, or 9, characterized in that the first N+-doped layer (61) and the P-doped layer (62) are made by epitaxial growth, and that the second N+-doped layer (63) is formed by an N+-doped diffusion from the first N+-doped polycrystalline layer into a region of the thickness of the P-conductive layer.

11. Highly dense FET random access storage matrix made in accordance with the method as claimed in any one of claims 6 to 10, characterized by the following structure:

— the mutually isolated monocrystalline silicon regions are respectively bisected into two equal halves by the second U-shaped openings (70),

— the conductive polycrystalline silicon (75) in the second U-shaped openings (70) is respectively connected via regions of the second polycrystalline silicon layer (74) to those in a row of analogue openings,

— the N+-doped layers (61, 63) are source-drain, the P-doped layer (61) between the N+-doped layers (61, 63) forms the channel, the first N+-doped polycrystalline silicon layer (66) forms a contact with the second N+-doped layer (63), the conductive polycrystalline silicon (75) in the second U-shaped openings forms the gate connection of the FETs, and

— regions of the first polycrystalline silicon layer (66) are connected to analogue regions in a column, and form the bit line, the PN junction between the P-conductive substrate (60) and the first N+-doped layer form the storage capacitor of a storage cell.

12. Storage matrix as claimed in claim 11, characterized in that the isolating surface layer (68) consists of a silicon dioxide coating.

## Revendications

1. Procédé de fabrication d'une matrice faite de transistors à effet de champ verticaux, fortement intégrés, isolés diélectriquement les uns vis-à-vis des autres; caractérisé par les opérations suivantes:

— application d'une couche dopée N+ (14) au-dessus d'une couche dopée P (12), elle-même appliquée sur un substrat de silicium (10) monocristallin de conductivité P,

— formation, par décapage, d'un dessin fait d'une première série d'ouvertures (16) en forme de U, à l'intérieur du corps semi-conducteur, jusque dans le substrat de conductivé P, en utilisant une attaque par ionis réactifs; ce qui permet d'isoler les unes vis-à-vis des autres diverses zones du substrat de silicium monocristallin et des couches appliquées sur celui-ci,

— remplissage des ouvertures à l'aide de dioxyde de silicium (18) et formation d'une couche de dioxyde de silicium (20) au-dessus de la couche dopée N+ (14),

— formation par décapage, d'une seconde série d'ouvertures (22) essentiellement en forme de U, à travers les couches (19, 14) se trouvant au-dessus du substrat de conductivité P (10), jusqu'à l'intérieur du substrat (10), en utilisant une attaque par ions réactifs; ce qui permet de partager en deux les zones de silicium monocristallin, qui restent isolées les unes vis-à-vis des autres,

— croissance de dioxyde de silicium (14) sur la surface de silicium monocristallin dans la seconde série d'ouvertures (22) en forme de U, en utilisant une oxydation thermique dans une atmosphère appropriée, en vue de la formation des oxydes de grille,

— dépôt de silicium polycristallin dopé (26, 28) dans la econde série d'ouvertures (22) et sur la surface de la couche de dioxyde de silicium (20), jusqu'à ce que la seconde série d'ouvertures soit remplie,

— élimination, par décapage, du silicium polycristallin dopé (28) en vue de former des lignes de transmission de mots d'une mémoire.

2. Procédé conforme à la revendication 1, caractérisé par le fait que les transistors à effet de champ, appartenant à une mémoire à accès aléatoire, sont disposés de telle façon que la couche dopée N+ (14), placée entre la première série d'ouvertures (16) en forme de U et remplies de dioxyde de silicium (18) et la seconde série d'ouvertures (22) en forme de U et remplies de silicium polycristallin (26), forme les lignes de transmission de bits (30) de la mémoire; et que la couche dopée P (12) forme les canaux des transistors à effet de champ.

3. Procédé conforme à la revendication 1 ou 2, caractérisé par le fait que les ouvertures en forme de U sont en peu plus grandes sur la surface que sur leur fond.

4. Procédé conforme à l'une des revendications 1 à 3, caractérisé par le fait que la couche dopée P (12) est appliquée sur le substrat (10) de conductivité P en utilisant un dépôt épitaxial; et que la couche dopée N+ (14) est formée dans la surface de la couche épitaxiale de conductivité P au moyen d'une diffusion globale, sur toute la surface.

5. Procédé conforme à l'une des revendications 1 à 3, caractérisé par le fait que la couche dopée P (12) est formée sur le substrat (10) de conductivité P, et la couche dopée N+ (14) sur la surface de la couche de conductivité P (12), en utilisant un dépôt épitaxial.

6. Procédé de fabrication d'une matrice faite de transistors à effet de champ verticaux fortement intégrés, réalisée auprès des parois de tranchées à l'intérieur d'un semi-conducteur; caractérisé en ce que, pour la réalisation de la matrice de la mémoire, à accès aléatoire, il comporte les étapes suivantes:

— formation d'une première couche dopée N+ (61) sur un substrat de silicium monocristallin (60) de conductivité P; formation d'une couche dopée P (62) sur la première couche dopée N+ (61), et formation d'une seconde couche dopée N+ (63) sur la couche dopée P (62),

— formation par décapage d'une première série d'ouvertures en forme de U à l'intérieur du corps semi-conducteur, en utilisant une attaque par ionis réactifs; ce qui permet d'isoler les unes vis-à-vis des autres diverses zones du substrat de silicium monocristallin et des couches appliquées sur celui-ci,

— remplissage de la premiére série d'ouvertures en forme de U avec du dioxyde de silicium (64),

— élimination, par décapage, de tout matériau de la surface de la deuxième couche dopée N+ (63),

— formation d'une première couche de silicium polycristallin (66), dopée N+, sur la surface de la deuxième couche de conductivité N+ (63) et sur les ouvertures remplies de dioxyde de silicium,

— réalisation d'ouvertures dans la première couche de silicium polycristallin (66) au-dessus de la première série d'ouvertures remplies de dioxyde de silicium (64),

— croissance d'une couche superficielle isolante (68) sur la surface de la première couche de silicium polycristallin (66),

— formation par décapage, d'une seconde série d'ouvertures (70), essentiellement en forme de U, à travers les couches (61, 62, 63, 66) se trouvant au-dessus du substrat de conductivité P (60) et jusqu'à l'intérieur de ce substrat (60), en utiliant une attaque par ions réactifs, en vue de partager en deux les zones de silicium monocristallin, qui restent isolées les unes vis-à-vis des autres,

—　formation de dioxyde de silicium (72) sur la surface de silicium monocristallin de la seconde série d'ouvertures en forme de U (70) au moyen d'une oxydation thermique, dans une atmosphère appropriée, en vue de la formation des oxydes de grille,

—　dépôt de silicium polycristallin dopé (74, 75) dans la seconde série d'ouvertures en forme de U et sur la couche superficielle isolante (68), jusqu'au moment où la seconde série d'ouvertures en forme de U se trouve remplie et où une seconde couche de silicium polycristallin (74) s'est formée sur la couche superficielle isolante (68),

—　élimination de parties de la seconde couche de silicium polycristallin (74), en vue de former des lignes de transmission de mots d'une mémoire à accès aléatoire.

7. Procédé conforme à la revendication 6, caractérisé par le fait que les couches de conductivité N+ et celles de conductivité P (61, 62, 63) sont formées au moyen d'un dépôt é épitaxial.

8. Procédé conforme à la revendication 6 ou 7, caractérisé par le fait que les premières ouvertures en forme de U sont remplies de dioxyde de silicium en exposant le corps semi-conducteur à une atmosphère d'oxydation et à une température élevée, en vue de l'oxydation thermique des surfaces de silicium à l'intérieur de la première série d'ouvertures en forme de U.

9. Procédé conforme à l'une des revendications 6 à 8, caractérisé par le fait qu'une couche de passivation est appliquée sur toute la surface de la matrice de mémoire.

10. Procédé conforme à l'une ou à plusieurs des revendications 6, 8 ou 9, caractérisé par le fait que la première couche dopée N+ (61) et la seconde couche dopée P (62) sont réalisées au moyen d'une application épitaxiale, et que la seconde couche dopée N+ (63) est introduite, au moyen d'une diffusion dopée N+ à partir de la couche polycristalline dopée N+, dans une zone ayant l'épaisseur de la couche de conductivité P.

11. Matrice de mémoire à accès aléatoire et à transistors à effet de champ fortement intégrés, fabriquée suivant le procédé conorme à l'une des revendications 6 à 10 caractérisée par la structure suivante:

—　les zones de silicium monocristallin, isolées les unes vis-à-vis des autres sont à chaque fois divisées, par la seconde série d'ouvertures en forme de U (70), en deux moitiés de grandeur égale,

—　le silicium polycristallin conducteur (75) se trouvant à l'intérieur de la seconde série d'ouvertures en forme de U (70) est à chaque fois relié, par l'intermédiaire de la seconde couche de silicium polycristallin (74), à celui se trouvant à l'intérieur d'une ligne horizontale d'ouvertures analogues,

—　les couches dopées N+ (61, 63) constituant les régions source/drain; la couche dopée P (61), disposée entre les couches dopées N+ (61, 63) constitue le canal; la première couche de silicium polycristallin dopée N+ (66) forme un contact avec la seconde couche dopée N+ (63); le silicium polycristallin conducteur (75), se trouvant à l'intérieur de la seconde série d'ouvertures en forme de U, forme l'électrode de grille des transistors à effet de champ,

—　des zones de la première couche de silicium polycristallin (66) sont reliées à des zones analogues disposées dans une fente et forment la ligne de transmission de bits; la jonction PN formée entre le substrat de conductivité P (60) et la première couche dopée N+ réalise le condensateur de mémoire d'une cellule de mémoire.

12. Matrice de mémoire conforme à la revendication 11, caractérisée par le fait que la couche superficielle isolante (68) se compose d'un revêtement de dioxyde de silicium.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14